# EUROPEAN PATENT SPECIFICATION

(11) **EP 3 799 021 B1**
(45) Date of publication and mention of the grant of the patent: **11.11.2026**
(21) Application number: 20197907.7
(22) Date of filing: 23.09.2020
(51) Int. Cl.: G09G 3/3208, G09G 3/20, H02M 3/00

(54) **POWER VOLTAGE GENERATOR AND DISPLAY DEVICE HAVING THE SAME**
LEISTUNGSSPANNUNGSGENERATOR UND ANZEIGEVORRICHTUNG DAMIT
GÉNÉRATEUR DE TENSION D'ALIMENTATION ET DISPOSITIF D'AFFICHAGE LE COMPORTANT

(30) Priority: 30.09.2019 KR 20190120953
(43) Date of publication of application: 31.03.2021
(73) Proprietor: Samsung Display Co., Ltd., Yongin-si Gyeonggi-do 17113 (KR)
(72) Inventor: KIM, Kyun Ho, Yongin-si (KR); KIM, Jung-taek, Seoul (KR); BAIK, Joon Suk, Suwon-si (KR); HAN, Sang Su, Hwaseong-si (KR); RYU, Jae Woo, Suwon-si (KR); LEE, Myung Ho, Anyang-si (KR)
(74) Representative: Marks & Clerk LLP

(56) References cited:
- EP-A1- 3 125 416
- US-A1- 2012 049 825

## Description

### BACKGROUND

### 1. Field

Embodiments of the present inventive concept relate to a power voltage generator and a display device including the power voltage generator. More particularly, embodiments of the present disclosure relate to a power voltage generator reducing a manufacturing cost and a power consumption and a display device including the power voltage generator.

EP3125416A1 discloses a DC-DC converter including: a switching circuit to change a voltage value of an input voltage, and to generate an output voltage; a feedback circuit connected between an output terminal to which the output voltage is supplied and a source of a first power, and to generate a feedback voltage corresponding to the output voltage; a gate pulse generator to generate a gate pulse to be supplied to the switching circuit by utilizing the feedback voltage; a current protector to control the switching circuit by utilizing the feedback voltage and the gate pulse; and a voltage protector to control the switching circuit by utilizing the feedback voltage

US2012049825A1 discloses a current mode Boost converter. The Boost converter operates in a pulse width modulation (PWM) mode or a pulse frequency modulation (PFM) mode. To prevent a load current with various probable magnitudes from varying a decision boundary between the PWM mode and the PFM mode, the Boost converter adaptively adjusts a trigger condition for the PFM mode according to a mean value of an inductor current or AC components of an inductor current of an inductor and a slope compensation current.

### 2. Description of the Related Art

Generally, a display device includes a display panel and a display panel driver. The display panel includes a plurality of gate lines, a plurality of data lines and a plurality of pixels. The display panel driver includes a gate driver outputting a gate signal to the plurality of gate lines, a data driver outputting a data voltage to the plurality of data lines and a power voltage generator providing a power voltage to the pixels.

Constant voltage control and constant current control may be performed with respect to the power voltage provided to the pixels. The constant current control module may be configured to lower an input voltage of the power voltage generator when the measured current has a value higher than a predetermined current.

In order to measure the current in the constant current control module, it is conventionally necessary to provide a large sensing resistor and an IC (integrated circuit) that detects the current caused by a voltage applied across the large sensing resistor and converts the current into a digital code.

In addition, since a large voltage is applied to the sensing resistor, problems such as heat generation, voltage drop of the power voltage, and an increase of power consumption may occur.

### SUMMARY

According to a first aspect there is provided a power voltage generator for generating an output voltage for driving a display device according to claim 1. Embodiments of the present inventive concept provide a power voltage generator sensing a signal at an electrode of a switch of a booster to operate constant current control.

Embodiments of the present inventive concept also provide a display device including the power voltage generator according to claim 7.

According to the power voltage generator of claim 1 and the display device of claim 7 including the power voltage generator, a constant current control may be operated by sensing the signal of the gate electrode of the switch of the booster. This means that the large sensing resistor for current sensing and the IC that detects the current caused by the voltage applied across the large sensing resistor and converts the current into a digital code may be omitted. Therefore, the manufacturing cost of the display device may be reduced.

In addition, heat generation, voltage drop of the power voltage, and an increase of power consumption, which may occur when a large voltage is applied to the sensing resistor, may be prevented.

### BRIEF DESCRIPTION OF THE DRAWINGS

The above and other features and advantages of the present inventive concept will become more apparent by describing in detailed embodiments thereof with reference to the accompanying drawings, in which:
FIG. 1 is a block diagram illustrating a display device according to an embodiment of the present disclosure;
FIG. 2 is a circuit diagram illustrating a power voltage generator of FIG. 1;
FIG. 3 is a table illustrating a target duty ratio signal of FIG. 2;
FIG. 4 is a timing diagram illustrating a signal in the power voltage generator of FIG. 2;
FIG. 5A is an equivalent circuit diagram of a booster shown in FIG. 2 when a switch of FIG. 2 is turned on;
FIG. 5B is an equivalent circuit diagram of the booster shown in FIG. 2 when the switch of FIG. 2 is turned off;
FIG. 6 is a circuit diagram illustrating a power voltage generator of a display device according to an embodiment of the present disclosure;
FIG. 7 is a circuit diagram illustrating a power voltage generator of an example display device; and
FIG. 8 is a circuit diagram illustrating a power voltage generator of an example display device.

### DETAILED DESCRIPTION OF THE EMBODIMENTS

Hereinafter, the present inventive concept will be explained in detail with reference to the accompanying drawings.

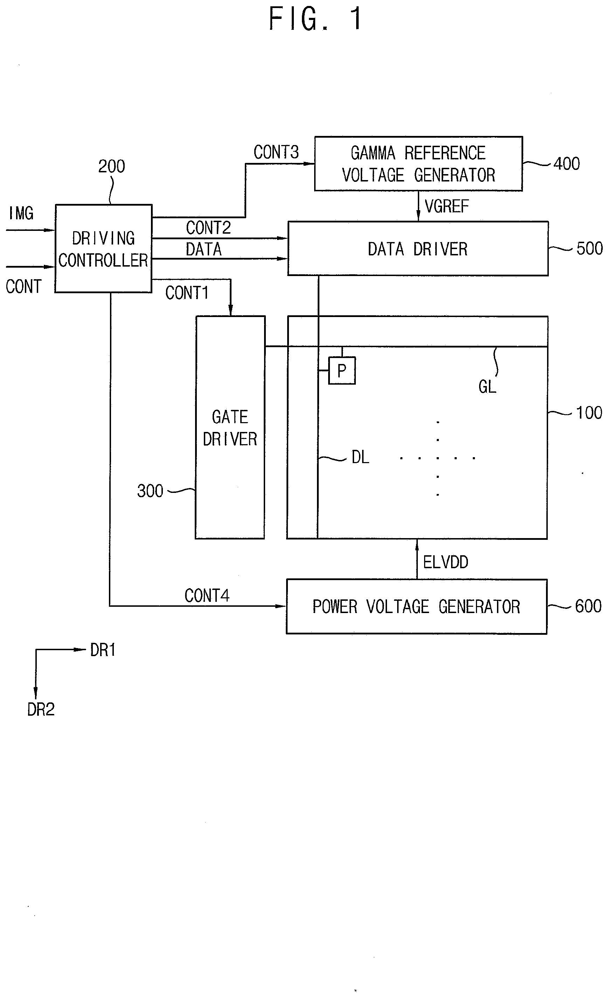

FIG. 1 is a block diagram illustrating a display device according to an embodiment of the present disclosure.

Referring to FIG. 1, the display device includes a display panel 100 and a display panel driver. The display panel driver includes a driving controller 200, a gate driver 300, a gamma reference voltage generator 400, a data driver 500 and a power voltage generator 600.

For example, the driving controller 200 and the data driver 500 may be integrally formed in one IC (integrated circuit). For example, the driving controller 200, the gamma reference voltage generator 400 and the data driver 500 may be integrally formed in one IC (integrated circuit). For example, the driving controller 200, the gate driver 300, the gamma reference voltage generator 400 and the data driver 500 may be integrally formed in one IC (integrated circuit).

The display panel 100 includes a display region and a peripheral region adjacent to the display region and surrounding the display region.

For example, the display panel 100 may be an organic light emitting diode display panel including an organic light emitting diode.

The display panel 100 includes a plurality of gate lines GL, a plurality of data lines DL and a plurality of pixels electrically connected to the gate lines GL and the data lines DL. The gate lines GL extend in a first direction DR1 and the data lines DL extend in a second direction DR2 crossing the first direction DR1.

The driving controller 200 receives input image data IMG and an input control signal CONT from an external apparatus, for example, a graphic controller. The input image data IMG may include red image data, green image data, and blue image data. The input image data IMG may further include white image data. The input image data IMG may further, or alternatively, include magenta image data, yellow image data, and cyan image data. The input control signal CONT may include a master clock signal and a data enable signal. The input control signal CONT may further include a vertical synchronizing signal and a horizontal synchronizing signal.

The driving controller 200 generates a first control signal CONT1, a second control signal CONT2, a third control signal CONT3, a fourth control signal CONT4 and a data signal DATA based on the input image data IMG and the input control signal CONT.

The driving controller 200 generates the first control signal CONT1 for controlling an operation of the gate driver 300 based on the input control signal CONT, and outputs the first control signal CONT1 to the gate driver 300. The first control signal CONT1 may include a vertical start signal and a gate clock signal.

The driving controller 200 generates the second control signal CONT2 for controlling an operation of the data driver 500 based on the input control signal CONT, and outputs the second control signal CONT2 to the data driver 500. The second control signal CONT2 may include a horizontal start signal and a load signal.

The driving controller 200 generates the data signal DATA based on the input image data IMG. The driving controller 200 outputs the data signal DATA to the data driver 500.

The driving controller 200 generates the third control signal CONT3 for controlling an operation of the gamma reference voltage generator 400 based on the input control signal CONT, and outputs the third control signal CONT3 to the gamma reference voltage generator 400.

The driving controller 200 generates the fourth control signal CONT4 for controlling an operation of the power voltage generator 600 based on the input image data IMG or the input control signal CONT, and outputs the fourth control signal CONT4 to the power voltage generator 600.

The gate driver 300 generates a plurality of gate signals for driving the gate lines GL in response to the first control signal CONT1 received from the driving controller 200. The gate driver 300 outputs the gate signals to the gate lines GL. For example, the gate driver 300 may sequentially output the gate signals to the gate lines GL. For example, the gate driver 300 may be mounted on the display panel 100. For example, the gate driver 300 may be integrated on the display panel 100.

For example, the gate lines GL may include a writing gate line to transmit a writing gate signal to the pixel. In addition, the gate lines GL may include an initializing gate line to transmit an initializing gate signal to the pixel.

The gamma reference voltage generator 400 generates a gamma reference voltage VGREF in response to the third control signal CONT3 received from the driving controller 200. The gamma reference voltage generator 400 provides the gamma reference voltage VGREF to the data driver 500. The gamma reference voltage VGREF has a value corresponding to a level of the data signal DATA.

In an embodiment, the gamma reference voltage generator 400 may be integrated in the driving controller 200, or integrated in the data driver 500.

The data driver 500 receives the second control signal CONT2 and the data signal DATA from the driving controller 200, and receives the gamma reference voltages VGREF from the gamma reference voltage generator 400. The data driver 500 converts the data signal DATA into data voltages having an analog type using the gamma reference voltages VGREF provided from the gamma reference voltage generator 400. The data driver 500 outputs the data voltages to the data lines DL.

The power voltage generator 600 may generate a power voltage to drive the display device. For example, the power voltage generator 600 may generate a power voltage to drive an organic light emitting diode (OLED) in the display panel 100. For example, the power voltage generator 600 may generate a high power voltage ELVDD to drive the organic light emitting diode (OLED) in the display panel 100.

For example, the power voltage generator 600 may further generate a low power voltage to drive the organic light emitting diode in the display panel 100. For example, the power voltage generator 600 may further generate a gate power voltage to drive the gate driver 300. For example, the power voltage generator 600 may further generate a data power voltage to drive the data driver 500. For example, the power voltage generator 600 may further generate a common voltage applied to the display panel 100.

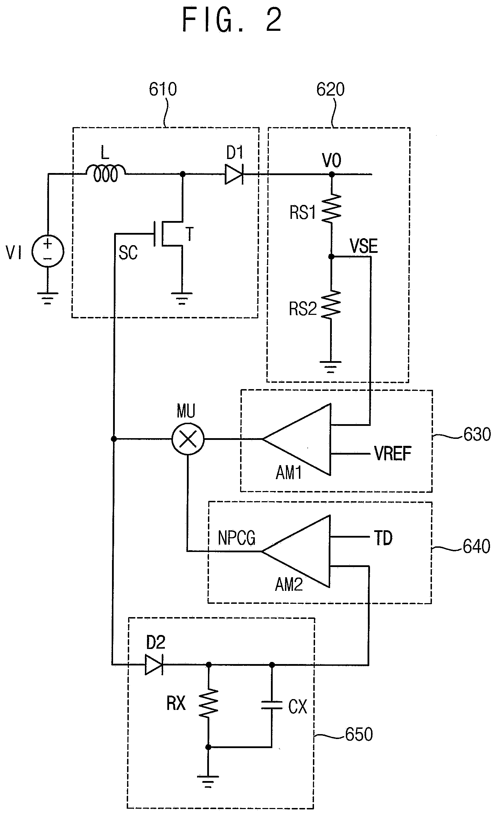

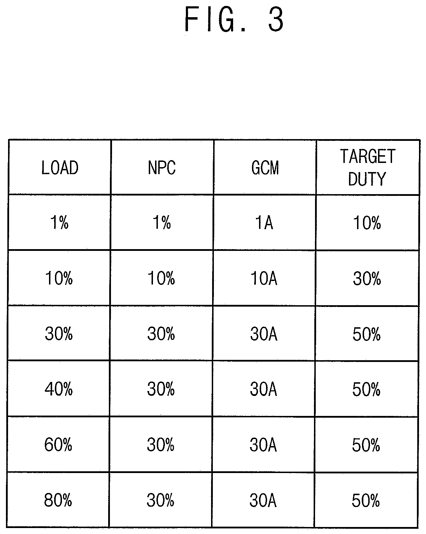

FIG. 2 is a circuit diagram illustrating a power voltage generator 600 of FIG. 1. FIG. 3 is a table illustrating a target duty ratio signal TD of FIG. 2.

Referring to FIGS. 1 to 3, the power voltage generator 600 includes a booster 610, a voltage sensor 620, a constant voltage controller 630, and a constant current controller 640.

The booster 610 boosts an input voltage VI to an output voltage VO based on the on-off operation of a switch T. The voltage sensor 620 generates a sensing voltage VSE by sensing the output voltage VO. The constant voltage controller 630 generates a first switching signal for controlling the switch T by comparing the sensing voltage VSE with a reference voltage VREF. The constant current controller 640 generates a gain NPCG based on a ratio of an electrode signal of the switch T and a target signal by comparing the electrode signal of the switch T with the target signal. In the present embodiment, the target signal is a target duty ratio signal TD for generating a target current, which is determined based on a load of input image data IMG of a display device. In the present embodiment, the electrode signal is a signal of a gate electrode of the switch T.

The power voltage generator 600 further includes a gain operator MU configured to generate a second switching signal SC by multiplying the gain NPCG with the first switching signal (which is an output from the constant voltage controller 630). The on-off operation of the switch T is controlled by the second switching signal SC.

The booster 610 includes an inductor L, a first diode D1, and the switch T. The inductor L includes a first terminal to which the input voltage VI is applied and a second terminal connected to a first electrode of the first diode D1. The switch may be a transistor. The switch T includes a gate electrode, a source electrode, and a drain electrode. The second switching signal SC is applied to the gate electrode of the switch T, and the drain electrode of the switch T is connected to the first electrode of the first diode D1. The source electrode of the switch T is connected to a ground. The first diode D1 includes the first electrode connected to the second terminal of the inductor L and a second electrode connected to the voltage sensor 620 to output the output voltage.

The voltage sensor 620 may include a first sensing resistor RS1 and a second sensing resistor RS2 which are connected in series. The first sensing resistor RS1 may include a first terminal connected to the second electrode of the first diode D1 to receive the output voltage from the booster 610 and a second terminal connected to a first terminal of the second sensing resistor RS2. The second sensing resistor RS2 may include a first terminal connected to the second terminal of the first sensing resistor RS1 and a second terminal connected to the ground. The voltage sensor 620 may sense a voltage between the first sensing resistor RS1 and the second sensing resistor RS2 which is the sensing voltage VSE corresponding to the output voltage VO according to the voltage divider rule between the first sensing resistor RS1 and the second sensing resistor RS2.

The constant voltage controller 630 may include a first operator (e.g. OP AMP) AM1 including a first input electrode to which the sensing voltage VSE is applied, a second input electrode to which the reference voltage VREF is applied, and an output electrode to output the first switching signal.

The power voltage generator 600 further includes a signal smoothing circuit 650. In the present embodiment, the electrode signal applied to the gate electrode of the switch T may be a first signal which is a signal applied to the gate electrode of the switch. As such, the first signal may be the same as the second switching signal SC. The first signal may be a pulse width modulation signal. The first signal may be the second switching signal SC which is an output signal from the gain controller MU.

The signal smoothing circuit 650 converts the first signal, which is the pulse width modulation signal, into a second signal, which is a direct current signal. For example, the signal smoothing circuit 650 may include a low pass filter.

The signal smoothing circuit 650 may include a second diode D2, a resistor RX, and a capacitor CX. The second diode D2 may include a first electrode to which the first signal is applied and a second electrode connected to a first terminal of the resistor RX. The resistor RX may include the first terminal connected to the second electrode of the second diode D2 and a second terminal connected to the ground. The capacitor CX may include a first electrode connected to the second electrode of the second diode D2 and a second electrode connected to the ground.

The constant current controller 640 may generate the gain NPCG by comparing the second signal with a target duty ratio signal TD for generating a target current GCM, which is determined based on the load of the input image data IMG of the display device.

The display device may have a net power control function for estimating power consumption of the display device based on the input image data IMG. For example, the net power control function may be operated by the driving controller 200 (see Fig. 1). For example, when the input image data IMG is configured to turn on an area of 1% of the display panel 100 to a set maximum luminance (e.g. 500 nits or 500 cd/m²), the load of the input image data IMG may be set to 1%. In addition, when the input image data IMG is configured to turn on an area of 10% of the display panel 100 to the maximum luminance (e.g. 500 nits or 500 cd/m²), the load of the input image data IMG may be set to 10%. However, due to the limitation of maximum current, the input image data IMG cannot turn on an area of 100% of the display panel 100 to the maximum luminance (e.g. 500 nits or 500 cd/m²). When the load of the input image data IMG is greater than a predetermined threshold value, the maximum luminance may be reset to the level lower than 500 nits (or 500 cd/m²) to control the maximum current of the display to be lower than a predetermined threshold value. This operation is called the net power control function. In a scenario where the maximum current of the display is set as the current obtained when the input image data IMG turns on an area of 30% of the display panel 100 to the maximum luminance (e.g. 500 nits or 500 cd/m²), if the input image data IMG required to turn on an area of 60% of the display panel 100 to the maximum luminance is input, the maximum luminance may be reduced from 500 nits (or 500 cd/m²) to 250 nits (or 250 cd/m²) to display the image to maintain the maximum current of the display within the set maximum value.

As shown in FIG. 3, the load LOAD of the input image data IMG may be the same as the net power control value NPC when the load LOAD of the input image data IMG has a value lower than the saturation level (e.g. 30%) of the net power control. In contrast, when the load LOAD of the input image data IMG has a value greater than the saturation level (e.g. 30%) of the net power control, the net power control value NPC no longer increases even when the load LOAD of the input image data IMG increases greater than the saturation level (e.g. 30%). Therefore, the saturation level (e.g. 30%) of the net power control is maintained.

In addition, the target current GCM is a current for implementing the net power control value NPC, the target current GCM may have a value proportional to the net power control value NPC. For convenience of explanation, when the target current GCM for implementing the net power control value NPC of 1% is 1A, the target current GCM for implementing the net power control value NPC of 10% may be 10A and the target current GCM for implementing the net power control value NPC of 30% may be 30A.

Similar to the net power control value NPC, the target current GCM may increase proportionally to the load LOAD of the input image data IMG until it reaches the saturation current which is, for example, 30A (as shown in FIG. 3). When the load LOAD of the input image data IMG increases greater than the saturation level, (for example 30% as in FIG. 3), the target current GCM may be maintained as the saturation current (e.g. 30A).

The target duty ratio TARGET DUTY refers to a duty ratio of the switch T of the power voltage generator 600 for implementing the net power control value NPC. Therefore, the target duty ratio TARGET DUTY may also have a value generally proportional to the net power control value NPC. For example, the target duty ratio TARGET DUTY for implementing the net power control value NPC of 1% may be 10%. For example, the target duty ratio TARGET DUTY for implementing the net power control value NPC of 10% may be 30%. For example, the target duty ratio TARGET DUTY for implementing the net power control value NPC of 30% may be 50%.

The numerical values shown in FIG. 3 are for the sake of convenience of explanation, and the present disclosure is not limited to the numerical values shown in FIG. 3.

The driving controller 200 may output at least one information (or value) of the net power control value NPC, the target current GCM, and the target duty ratio TARGET DUTY to the power voltage generator 600.

According to the present embodiment, the constant current controller 640 may generate the gain NPCG by comparing the second signal with the target duty ratio signal TD for generating the target current GCM determined based on the load LOAD of the input image data IMG of the display device. As described above, the target current GCM may increase as the load LOAD of the input image data IMG increases, and may be maintained at the saturation current after the target current GCM reaches the saturation current.

The constant current controller 640 may include a second operator (e.g. OP AMP) AM2 including a first input electrode to which the target duty ratio signal TD is input, a second input electrode to which the second signal is applied, and an output electrode connected to the gain operator MU and outputting the gain NPCG to the gain operator MU.

For example, when the duty ratio represented by the target duty ratio signal TD is 30% and the measured duty ratio represented by the second signal is 35%, the second operator AM2 may output the gain NPCG of 6/7. In addition, when the duty ratio represented by the target duty ratio signal TD is 30% and the measured duty ratio represented by the second signal is 40%, the second operator AM2 may output the gain NPCG of 3/4.

When an output current of the power voltage generator 600 increases, the level of the second signal may increase and when the output current of the power voltage generator 600 decreases, the level of the second signal may decrease. As described above, the constant current controller 640 may indirectly determine the level of the output current of the power voltage generator 600 based on the electrode signal which is supplied to the gate electrode of the switch T.

The constant current controller 640 may perform the constant current control based on the level of the output current of the power voltage generator 600, which is indirectly determined based on the electrode signal which is applied to the gate electrode of the switch T. Accordingly, it is possible to omit the large capacitance sensing resistor for current sensing and an IC (integrated circuit) for converting the current caused by the voltage applied across the sensing resistor(s) into a digital code.

The gain operator MU generates the second switching signal SC by multiplying the gain NPCG with the first switching signal, and the second switching signal SC is applied as the gate signal of the switch T to perform the constant current control of the power voltage generator 600.

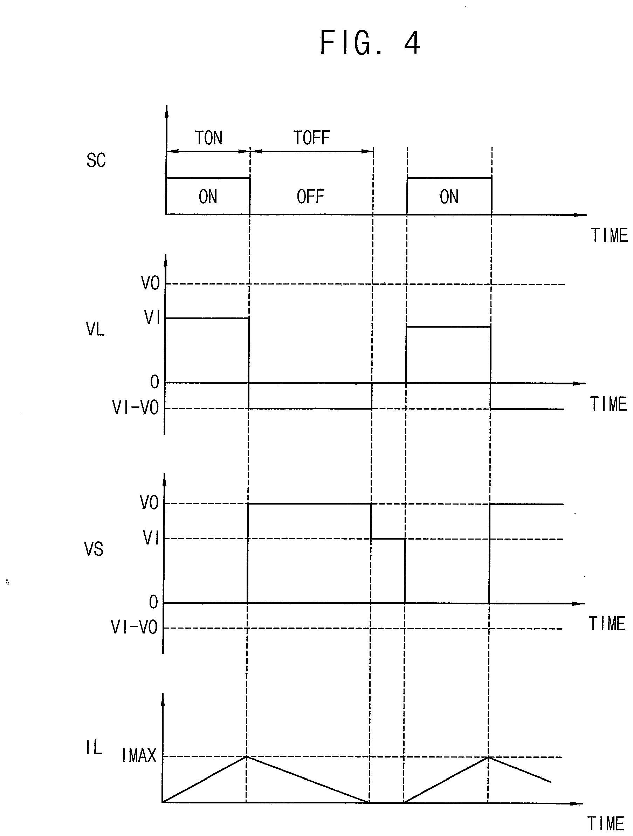

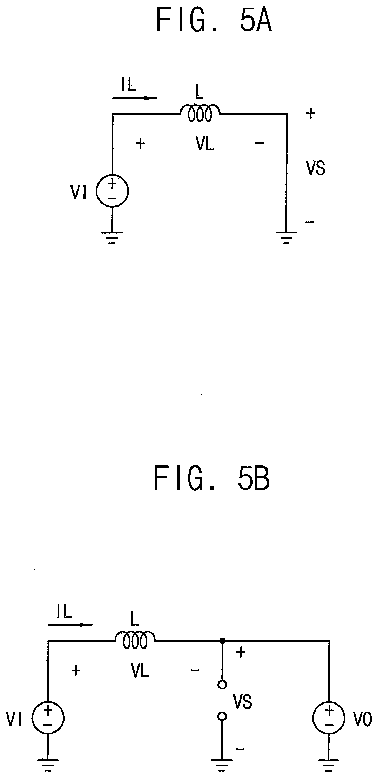

FIG. 4 is a timing diagram illustrating a signal in the power voltage generator 600 of FIG. 2. FIG. 5A is an equivalent circuit diagram of the booster 610 shown in FIG. 2 when the switch T of FIG. 2 is turned on. FIG. 5B is an equivalent circuit diagram of the booster 610 shown in FIG. 2 when the switch T of FIG. 2 is turned off.

Referring to FIGS. 1 to 5B, when the switch T of the booster 610 is turned on (TON duration) by the second switching signal SC as disclosed in FIG. 5A, the input voltage VI is charged in the inductor L so that the voltage VL of the inductor L is equal to the input voltage VI (VI = VL).

When the switch T of the booster 610 is turned off (TOFF duration) by the second switching signal SC as disclosed in FIG. 5B, the output voltage VO is equal to the subtraction of a voltage VL of the inductor L from the input voltage VI (VO = VI-VL).

In FIG. 4, VS denotes a voltage applied across the switch T.

During the turn-on duration (TON duration) of the switch T, the current flowing through the inductor IL may gradually increase to IMAX, and during the turn-off duration (TOFF duration) of the switch T, the current flowing through the inductor IL may gradually decrease as disclosed in FIG. 4.

When the input voltage of the booster 610 is VI, the output voltage of the booster 610 is VO, an output current of the booster 610 is IO, a measured duty ratio of the switch is D, an inductance of the inductor is L, and a time is t, the output current IO of the booster 610 may be expressed as follows: $IO = \frac{{VI}^{2} {D}^{2} t}{2 L \left(VO-VI\right)}$ That is, the output current IO of the booster 610 may be proportional to the square of the measurement duty ratio D of the switch T. Similarly, the magnitude of the second signal proportional to the output current IO of the booster 610 may be proportional to the square of the measurement duty ratio D of the switch T. As described above, the constant current controller 640 may indirectly determine the level of the output current IO of the booster 610 by using the electrode signal applied to the gate electrode of the switch T without directly sensing the output current IO of the booster 610.

According to the present embodiment, the constant current control is performed by sensing the signal of the gate electrode of the switch T of the booster 610. This means that the large sensing resistor for current sensing and the IC (integrated circuit) that detects the current caused by the voltage applied across the large sensing resistor and converts the current into a digital code may be omitted. Therefore, the manufacturing cost of the display device may be reduced.

In addition, heat generation, voltage drop of the power voltage, and an increase of power consumption, which may occur when a large voltage is applied to the sensing resistor, may be prevented.

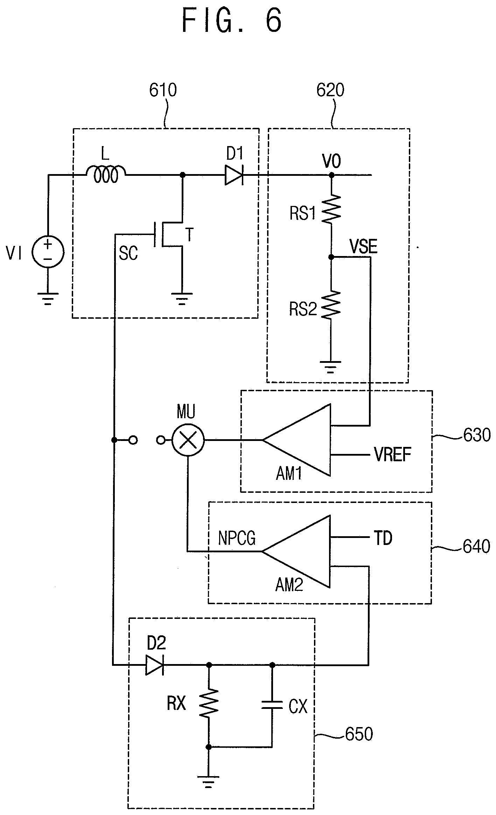

FIG. 6 is a circuit diagram illustrating the power voltage generator 600 of the display device according to an embodiment of the present disclosure.

The power voltage generator 600 and the display apparatus including the power voltage generator 600 according to the present embodiment is substantially the same as the power voltage generator 600 and the display apparatus including the power voltage generator 600 of the previous embodiment explained referring to FIGS. 1 to 5B, except for the structure of the power voltage generator 600. Thus, the same reference numerals will be used to refer to the same or like parts as those described in the previous embodiment of FIGS. 1 to 5B and any repetitive explanation concerning the above elements will be omitted.

Referring to FIGS. 1 and 3 to 6, the display device includes a display panel 100 and a display panel driver. The display panel driver includes a driving controller 200, a gate driver 300, a gamma reference voltage generator 400, a data driver 500 and a power voltage generator 600.

The power voltage generator 600 includes a booster 610, a voltage sensor 620, a constant voltage controller 630, and a constant current controller 640.

The booster 610 boosts an input voltage VI to an output voltage VO based on the on-off operation of a switch T. The voltage sensor 620 generates a sensing voltage VSE by sensing the output voltage VO. The constant voltage controller 630 generates a first switching signal for controlling the switch T by comparing the sensing voltage VSE with a reference voltage VREF. The constant current controller 640 generates a gain NPCG based on a ratio of an electrode signal applied to the gate electrode of the switch T and a target signal by comparing the electrode signal applied to the gate electrode of the switch T with the target signal. In the present embodiment, the target signal is a target duty ratio signal TD for generating a target current determined based on a load of input image data IMG of a display device. In the present embodiment, the electrode signal is a signal applied to a gate electrode of the switch T. In the present embodiment, the electrode signal is the same as the second switching signal SC.

The power voltage generator 600 further includes a gain operator MU configured to generate a second switching signal SC by multiplying the gain NPCG with the first switching signal. The on-off operation of the switch T is controlled by the second switching signal SC.

The booster 610 includes an inductor L, a first diode D1, and the switch T. The inductor L includes a first terminal to which the input voltage VI is applied and a second terminal connected to a first electrode of the first diode D1. The switch may be a transistor. The switch T includes a gate electrode, a source electrode, and a drain electrode, in which the second switching signal SC is applied to the gate electrode, and the drain electrode is connected to the first electrode of the first diode D1. The source electrode of the switch T is connected to a ground. The first diode D1 includes the first electrode connected to the second terminal of the inductor L and a second electrode connected to the voltage generator and supplying the output voltage to the voltage generator.

The voltage sensor 620 may include a first sensing resistor RS1 and a second sensing resistor RS2 which are connected in series. The first sensing resistor RS1 may include a first terminal connected to the second electrode of the first diode D1 to receive the output voltage from the booster 610 and a second terminal connected to a first terminal of the second sensing resistor RS2. The second sensing resistor RS2 may include a first terminal connected to the second terminal of the first sensing resistor RS1 and a second terminal connected to the ground. The voltage sensor 620 may sense the sensing voltage VSE corresponding to the output voltage VO by using the voltage divider rule between the first sensing resistor RS1 and the second sensing resistor RS2.

The constant voltage controller 630 may include a first operator AM1 including a first input electrode to which the sensing voltage VSE is applied, a second input electrode to which the reference voltage VREF is applied, and an output electrode outputting the first switching signal.

In the present embodiment, the constant current controller 640 shuts down the power voltage generator 600 when a difference between the target duty ratio signal TD and the second signal which is applied to the gate electrode of the switch T in the booster 610 and is received through the signal smoothing circuit 650 is greater than or equal to a threshold. For example, when the difference between the target duty ratio signal TD and the second signal is greater than or equal to the threshold, it may be determined that a short circuit occurs in the display panel 100 or a part of a voltage application line.

That is, the constant current controller 640 of the present embodiment may perform the constant current control operation and the protection operation.

For example, when the difference between the target duty ratio signal TD and the second signal is greater than or equal to the threshold, the second operator AM2 may output the gain NPCG of zero (0).

According to the present embodiment, the constant current control is operated by sensing the signal of the gate electrode of the switch T of the booster 610 (i.e. the electrode signal). As a result, the large sensing resistor for current sensing and the IC (integrated circuit) that detects the current caused by the voltage applied across the large sensing resistor and converts the current into a digital code may be omitted. Therefore, the manufacturing cost of the display device may be reduced.

In addition, heat generation, voltage drop of the power voltage, and an increase of power consumption, which may occur when a large voltage is applied to the sensing resistor, may be prevented.

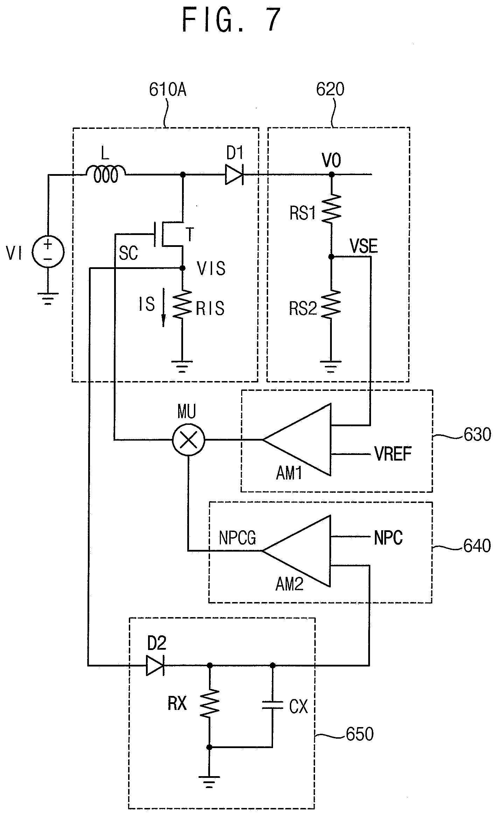

FIG. 7 is a circuit diagram illustrating a power voltage generator 600 of an example display device.

The power voltage generator 600 and the display apparatus including the power voltage generator 600 according to the present example is substantially the same as the power voltage generator 600 and the display apparatus including the power voltage generator 600 of the previous embodiment explained referring to FIGS. 1 to 5B, except for the structure of the power voltage generator 600. Thus, the same reference numerals will be used to refer to the same or like parts as those described in the previous embodiment of FIGS. 1 to 5B and any repetitive explanation concerning the above elements will be omitted.

Referring to FIGS. 1 and 3 to 5B and 7, the display device includes a display panel 100 and a display panel driver. The display panel driver includes a driving controller 200, a gate driver 300, a gamma reference voltage generator 400, a data driver 500 and a power voltage generator 600.

The power voltage generator 600 includes a booster 610A, a voltage sensor 620, a constant voltage controller 630, and a constant current controller 640.

The booster 610A boosts an input voltage VI to an output voltage VO based on the on-off operation of a switch T. The voltage sensor 620 generates a sensing voltage VSE by sensing the output voltage VO. The constant voltage controller 630 generates a first switching signal for controlling the switch T by comparing the sensing voltage VSE with a reference voltage VREF. The constant current controller 640 generates a gain NPCG based on a ratio of an electrode signal of the switch T and a target signal by comparing the electrode signal of the switch T with the target signal. In the present example, the target signal may be a net power control signal NPC determined based on the load of the input image data IMG of the display device. In the present example, the electrode signal may be a signal of the source electrode of the switch T. For example, the electrode signal may be a source current IS flowing through the source electrode of the switch T.

The power voltage generator 600 further includes a gain operator MU configured to generate a second switching signal SC by multiplying the gain NPCG with the first switching signal. The on-off operation of the switch T is controlled by the second switching signal SC.

The booster 610A includes an inductor L, a first diode D1, and the switch T. The inductor L includes a first terminal to which the input voltage VI is applied and a second terminal connected to a first electrode of the first diode D1. The switch T includes agate electrode, a source electrode, and a drain electrode, in which the second switching signal SC is applied to the gate electrode, and the drain electrode is connected to the first electrode of the first diode D1. The first diode D1 includes the first electrode connected to the second terminal of the inductor L and a second electrode connected to the voltage sensor 620 and supplying the output voltage to the voltage sensor 620.

The voltage sensor 620 may include a first sensing resistor RS1 and a second sensing resistor RS2 which are connected in series. The first sensing resistor RS1 may include a first terminal connected to the second electrode of the first diode D1 to receive the output voltage from the booster 610A and a second terminal connected to a first terminal of the second sensing resistor RS2. The second sensing resistor RS2 may include a first terminal connected to the second terminal of the first sensing resistor RS1 and a second terminal connected to the ground. The voltage sensor 620 may sense the sensing voltage VSE corresponding to the output voltage VO by using the voltage divider rule between the first sensing resistor RS1 and the second sensing resistor RS2.

The constant voltage controller 630 may include a first operator AM1 including a first input electrode to which the sensing voltage VSE is applied, a second input electrode to which the reference voltage VREF is applied, and an output electrode outputting the first switching signal.

The booster 610A may further include a current sensing resistor RIS disposed between the source electrode of the switch T and the ground. The current sensing voltage VIS of the first terminal of the current sensing resistor RIS may be output to the constant power controller through the signal smoothing circuit 650.

The signal of the source electrode of the switch T may be a first signal. The first signal may be a triangular wave signal. The power voltage generator 600 may further include a signal smoothing circuit 650 configured to convert the first signal, which is the triangle wave signal, into a second signal, which is a DC signal.

The signal smoothing circuit 650 may include a second diode D2, a resistor RX, and a capacitor CX.

The constant current controller 640 may generate the gain NPCG by comparing the second signal with the net power control signal NPC determined based on the load of the input image data IMG of the display device. The net power control signal NPC may increase proportional to the load of the input image data IMG, and maintain the saturation level after it reaches the saturation level.

The constant current controller 640 may include a second operator AM2 including a first input electrode to which the net power control signal NPC is input, a second input electrode to which the second signal is applied, and an output electrode to output the gain NPCG to the gain operator MU.

The gain operator MU generates the second switching signal SC by multiplying the gain NPCG with the first switching signal, and the second switching signal SC is applied as the gate signal of the switch T to perform the constant current control of the power voltage generator 600.

According to the present example, the constant current control is performed by sensing the signal of the source electrode of the switch T in the booster 610A. This means that the large sensing resistor for current sensing and the IC (integrated circuit) that detects the current caused by the voltage applied across the large sensing resistor and converts the current into a digital code may be omitted. Therefore, the manufacturing cost of the display device may be reduced.

In addition, heat generation, voltage drop of the power voltage, and an increase of power consumption, which may occur when a large voltage is applied to the sensing resistor, may be prevented.

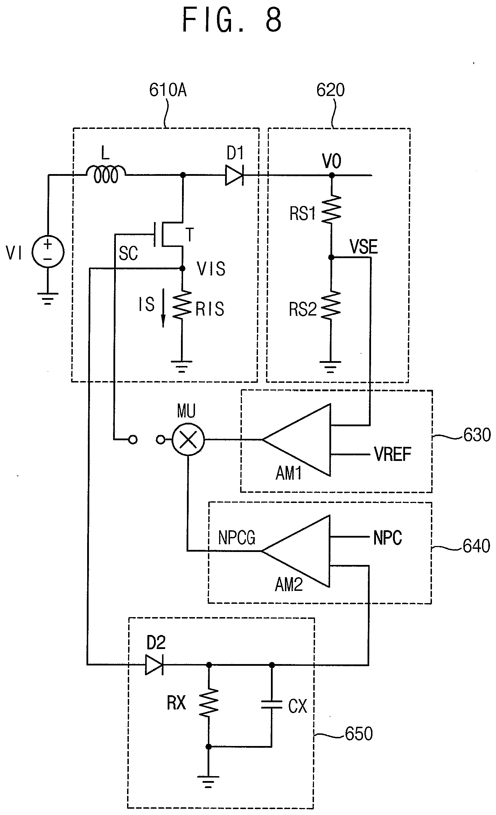

FIG. 8 is a circuit diagram illustrating a power voltage generator of an example display device.

The power voltage generator 600 and the display apparatus including the power voltage generator 600 according to the present example is substantially the same as the power voltage generator 600 and the display apparatus including the power voltage generator 600 of the previous example explained referring to FIG. 7 except for the structure of the power voltage generator 600. Thus, the same reference numerals will be used to refer to the same or like parts as those described in the previous example of FIG. 7 and any repetitive explanation concerning the above elements will be omitted.

Referring to FIGS. 1 and 3 to 5B and 8, the display device includes a display panel 100 and a display panel driver. The display panel driver includes a driving controller 200, a gate driver 300, a gamma reference voltage generator 400, a data driver 500 and a power voltage generator 600.

The power voltage generator 600 includes a booster 610A, a voltage sensor 620, a constant voltage controller 630, and a constant current controller 640.

The booster 610A boosts an input voltage VI to an output voltage VO based on the on-off operation of a switch T. The voltage sensor 620 generates a sensing voltage VSE by sensing the output voltage VO. The constant voltage controller 630 generates a first switching signal for controlling the switch T by comparing the sensing voltage VSE with a reference voltage VREF. The constant current controller 640 generates a gain NPCG based on a ratio of an electrode signal of the switch T and a target signal by comparing the electrode signal of the switch T with the target signal. In the present example, the target signal may be a net power control signal NPC determined based on the load of the input image data IMG of the display device. In the present example, the electrode signal is a signal of the source electrode of the switch T.

The power voltage generator 600 further includes a gain operator MU configured to generate a second switching signal SC by multiplying the gain NPCG with the first switching signal. The on-off operation of the switch T is controlled by the second switching signal SC.

The booster 610A includes an inductor L, a first diode D1, and the switch T. The inductor L includes a first terminal to which the input voltage VI is applied and a second terminal connected to a first electrode of the first diode D1. The switch T includes a gate electrode, a source electrode, and a drain electrode, in which the second switching signal SC is applied to the gate electrode, and the drain electrode is connected to the first electrode of the first diode D1. The first diode D1 includes the first electrode connected to the second terminal of the inductor L and a second electrode connected to the voltage sensor 620 and outputting the output voltage to the voltage sensor 620.

The voltage sensor 620 may include a first sensing resistor RS1 and a second sensing resistor RS2 which are connected in series. The first sensing resistor RS1 may include a first terminal connected to the second electrode of the first diode D1 to receive the output voltage from the booster 610A and a second terminal connected to a first terminal of the second sensing resistor RS2. The second sensing resistor RS2 may include a first terminal connected to the second terminal of the first sensing resistor RS1 and a second terminal connected to the ground. The voltage sensor 620 may sense the sensing voltage VSE corresponding to the output voltage VO by using the voltage divider rule between the first sensing resistor RS1 and the second sensing resistor RS2.

The constant voltage controller 630 may include a first operator AM1 including a first input electrode to which the sensing voltage VSE is applied, a second input electrode to which the reference voltage VREF is applied, and an output electrode outputting the first switching signal to the gain operator MU.

In the present example, the constant current controller 640 shuts down the power voltage generator 600 when a difference between the net power control signal NPC and the second signal applied to a gate electrode of the switch T of the booster 610A and received through the signal smoothing circuit 650 is greater than or equal to a threshold. For example, when the difference between the net power control signal NPC and the second signal is greater than or equal to the threshold, it may be determined that a short circuit occurs in the display panel 100 or a part of the voltage application line.

That is, the constant current controller 640 of the present example may perform the constant current control operation and the protection operation.

For example, when the difference between the net power control signal NPC and the second signal is greater than or equal to the threshold, the second operator AM2 may output the gain NPCG of zero (0).

According to the present embodiment, the constant current control is performed by sensing the signal of the gate electrode of the switch T of the booster 610A. This means that the large sensing resistor for current sensing and the IC that detects the current caused by the voltage applied across the large sensing resistor and converts the current into a digital code may be omitted. Therefore, the manufacturing cost of the display device may be reduced.

In addition, heat generation, voltage drop of the power voltage, and an increase of power consumption, which may occur when a large voltage is applied to the sensing resistor, may be prevented.

According to the present inventive concept as explained above, the manufacturing cost of the display apparatus and the power consumption of the display apparatus may be reduced.

The foregoing is illustrative of the present inventive concept and is not to be construed as limiting thereof. Although a few embodiments of the present inventive concept have been described, those skilled in the art will readily appreciate that many modifications are possible in the embodiments without materially departing from the scope of the appended claims. The present inventive concept is defined by the following claims.

## Claims

1. A power voltage generator for generating an output voltage for driving a display device, the power voltage generator comprising:
a booster (610) comprising an inductor (L), a first diode (D1), and a switch (T), wherein the booster (610) is configured to boost an input voltage to an output voltage based on an on-off operation of the switch (T) and wherein:
the inductor (L) includes a first terminal configured to receive the input voltage and a second terminal connected to a first electrode of the first diode (D1),
the switch (T) includes a gate electrode, a source electrode and a drain electrode, the drain electrode being connected to the first electrode of the first diode (D1), the source electrode being connected to ground, and
a second electrode of the first diode (D1) is configured to output the output voltage;
a voltage sensor (620) connected to the second electrode and configured to generate a sensing voltage by sensing the output voltage;
a constant voltage controller (630) configured to generate a first switching signal by comparing the sensing voltage with a reference voltage;
a signal smoothing circuit (650) having an input connected to the gate electrode of the switch (T) and an output connected to a constant current controller (640), wherein the signal smoothing circuit is configured to convert a pulse width modulation signal at the gate electrode of the switch (T) into a direct current signal, wherein the constant current controller (640) is configured to compare the direct current signal and a target signal (TD) and to generate a gain based on a ratio of the direct current signal and the target signal, wherein the constant current controller (640) is configured to shut down the power voltage generator by outputting a gain of zero when a difference between the target signal and the direct current signal is greater than or equal to a threshold, wherein the target signal (TD) is based on a load of an input image data received by the display device; and
a gain operator (MU) configured to generate a second switching signal, being the pulse width modulation signal, by multiplying the gain with the first switching signal and configured to apply the second switching signal to the gate electrode to control the on-off operation of the switch (T).

2. The power voltage generator of claim 1, wherein the constant current controller includes a second operator including a first input electrode to which the target signal is input, a second input electrode configured to receive the second switching signal, and an output electrode connected to the gain operator (MU) and configured to output the gain to the gain operator (MU).

3. The power voltage generator of any preceding claim, wherein, when the input voltage of the booster (610) is VI, the output voltage of the booster (610) is VO, an output current of the booster (610) is IO, a duty ratio of the signal at the gate of the switch (T) is D, an inductance of the inductor (L) is L, and a time is t, the output current of the booster IO is represented as follows: $IO = \frac{{VI}^{2} {D}^{2} t}{2 L \left(VO-VI\right)}$

4. The power voltage generator of claim 1, wherein:
the signal smoothing circuit (650) includes a second diode (D2), a resistor (RX), and a capacitor (CX);
the second diode (D2) includes a first electrode connected to the gate electrode of the switch (T) and a second electrode connected to a first terminal of the resistor (RX);
the resistor (RX) includes the first terminal connected to the second electrode of the second diode (D2) and a second terminal connected to a ground; and
the capacitor (CX) includes a first electrode connected to the second electrode of the second diode (D2) and a second electrode connected to a ground.

5. The power voltage generator of any preceding claim, wherein the voltage sensor (620) includes a first sensing resistor (RS1) and a second sensing resistor (RS2),
the first sensing resistor (RS1) includes a first terminal connected to the second electrode of the first diode (D1) and a second terminal connected to a first terminal of the second sensing resistor (RS2), and
the second sensing resistor (RS2) includes a first terminal connected to the second terminal of the first sensing resistor (RS1) and a second terminal connected to a ground.

6. The power voltage generator of any preceding claim, wherein the constant voltage controller (630) includes a first operator including a first input electrode configured to receive the sensing voltage, a second input electrode configured to receive the reference voltage, and an output electrode connected to the gain operator (MU) and configured to output the first switching signal to the gain operator (MU).

7. A display device comprising:
a display panel (100) including a plurality of gate lines (GL), a plurality of data lines (DL), and a plurality of pixels connected to the gate lines (GL) and the data lines (DL) and configured to display an image based on input image data;
a gate driver (300) configured to output gate signals to the gate lines (GL);
a data driver (500) configured to output data voltages to the data lines (DL); and
the power voltage generator (600) according to any preceding claim configured to apply the output voltage to the pixels.

8. The display device of claim 7 further comprising:
a driving controller (200) configured to output to the power voltage generator (600) the target signal representative of a target current determined based on the load of the input image data received by the display device, wherein the target current increases as the load of the input image data increases and maintains a saturation current after the target current reaches the saturation current.

## Patentansprüche

1. Leistungsspannungsgenerator zur Erzeugung einer Ausgangsspannung zum Ansteuern einer Anzeigevorrichtung, wobei der Leistungsspannungsgenerator Folgendes umfasst:
einen Booster (610), der eine Induktivität (L), eine erste Diode (D1) und einen Schalter (T) umfasst, wobei der Booster (610) so konfiguriert ist, dass er eine Eingangsspannung basierend auf einem Ein-Aus-Betrieb des Schalters (T) auf eine Ausgangsspannung erhöht, und wobei:
die Induktivität (L) einen ersten Anschluss, der so konfiguriert ist, dass er eine Eingangsspannung empfängt, und einen zweiten Anschluss einschließt, der mit einer ersten Elektrode der ersten Diode (D1) verbunden ist,
der Schalter (T) eine Gate-Elektrode, eine Source-Elektrode und eine Drain-Elektrode einschließt, wobei die Drain-Elektrode mit der ersten Elektrode der ersten Diode (D1) verbunden ist, die Source-Elektrode mit Masse verbunden ist, und
eine zweite Elektrode der ersten Diode (D1) so konfiguriert ist, dass sie die Ausgangsspannung ausgibt;
einen Spannungssensor (620), der mit der zweiten Elektrode verbunden ist und so konfiguriert ist, dass er durch Messung der Ausgangsspannung eine Messspannung erzeugt;
ein Konstantspannungssteuereinheit (630), die so konfiguriert ist, dass sie ein erstes Schaltsignal durch Vergleichen der Messspannung mit einer Referenzspannung erzeugt;
eine Signalglättungsschaltung (650), die einen Eingang aufweist, der mit der Gate-Elektrode des Schalters (T) verbunden ist, und einen Ausgang, der mit einer Konstantstromsteuereinheit (640) verbunden ist, wobei die Signalglättungsschaltung so konfiguriert ist, dass sie ein Pulsweitenmodulationssignal an der Gate-Elektrode des Schalters (T) in ein Gleichstromsignal umwandelt, wobei die Konstantstromsteuereinheit (640) so konfiguriert ist, dass sie das Gleichstromsignal mit einem Zielsignal (TD) vergleicht und eine Verstärkung basierend auf dem Verhältnis des Gleichstromsignals und des Zielsignals erzeugt, wobei die Konstantstromsteuereinheit (640) so konfiguriert ist, dass sie den Spannungsgenerator durch Ausgabe einer Verstärkung von Null abschaltet, wenn die Differenz zwischen dem Zielsignal und dem Gleichstromsignal größer oder gleich einem Schwellenwert ist, wobei das Zielsignal (TD) auf einer Last aus Eingangsbilddaten basiert, die von der Anzeigevorrichtung empfangen werden; und
einen Verstärkungsoperator (MU), der so konfiguriert ist, dass er durch Multiplikation der Verstärkung mit dem ersten Schaltsignal ein zweites Schaltsignal, das das Pulsweitenmodulationssignal ist, erzeugt und so konfiguriert ist, dass er das zweite Schaltsignal an die Gate-Elektrode anlegt, um den Ein-Aus-Betrieb des Schalters (T) zu steuern.

2. Leistungsspannungsgenerator nach Anspruch 1, wobei die Konstantstromsteuereinheit einen zweiten Operator einschließt, der eine erste Eingangselektrode, in die das Zielsignal eingegeben wird, eine zweite Eingangselektrode, die so konfiguriert ist, dass sie das zweite Schaltsignal empfängt, und eine Ausgangselektrode einschließt, die mit dem Verstärkungsoperator (MU) verbunden ist und so konfiguriert ist, dass sie die Verstärkung an den Verstärkungsoperator (MU) ausgibt.

3. Leistungsspannungsgenerator nach einem vorstehenden Anspruch, wobei, wenn die Eingangsspannung des Boosters (610) VI ist, die Ausgangsspannung des Boosters (610) VO ist, der Ausgangsstrom des Boosters (610) IO ist, das Tastverhältnis des Signals am Gate des Schalters (T) D ist, die Induktivität der Spule (L) L ist und die Zeit t ist, der Ausgangsstrom des Boosters IO wie folgt dargestellt wird: $I / O = \frac{{VI}^{2} {D}^{2} t}{2 L \left(VO-VI\right)}$

4. Leistungsspannungsgenerator nach Anspruch 1, wobei:
die Signalglättungsschaltung (650) eine zweite Diode (D2), einen Widerstand (RX) und einen Kondensator (CX) einschließt;
die zweite Diode (D2) eine erste Elektrode, die mit der Gate-Elektrode des Schalters (T) verbunden ist, und eine zweite Elektrode einschließt, die mit einem ersten Anschluss des Widerstands (RX) verbunden ist;
der Widerstand (RX) einen ersten Anschluss, der mit der zweiten Elektrode der zweiten Diode (D2) verbunden ist, und einen zweiten Anschluss einschließt, der mit Masse verbunden ist; und
der Kondensator (CX) eine erste Elektrode, die mit der zweiten Elektrode der zweiten Diode (D2) verbunden ist, und eine zweite Elektrode einschließt, die mit Masse verbunden ist.

5. Leistungsspannungsgenerator nach einem vorstehenden Anspruch, wobei der Spannungssensor (620) einen ersten Messwiderstand (RS1) und einen zweiten Messwiderstand (RS2) einschließt,
der erste Messwiderstand (RS1) einen ersten Anschluss , der mit der zweiten Elektrode der ersten Diode (D1) verbunden ist, und einen zweiten Anschluss einschließt, der mit einem ersten Anschluss des zweiten Messwiderstands (RS2) verbunden ist, und
der zweite Messwiderstand (RS2) einen ersten Anschluss, der mit dem zweiten Anschluss des ersten Messwiderstands (RS1) verbunden ist, und einen zweiten Anschluss einschließt, der mit Masse verbunden ist.

6. Leistungsspannungsgenerator nach einem vorstehenden Anspruch, wobei die Konstantspannungssteuereinheit (630) einen ersten Operator einschließt, der eine erste Eingangselektrode, die so konfiguriert ist, dass sie die Messspannung empfängt, eine zweite Eingangselektrode, die so konfiguriert ist, dass sie die Referenzspannung empfängt, und eine Ausgangselektrode einschließt, die mit dem Verstärkungsoperator (MU) verbunden ist und so konfiguriert ist, dass sie das Schaltsignal an den Verstärkungsoperator (MU) ausgibt.

7. Anzeigevorrichtung, die Folgendes umfasst:
ein Anzeigefeld (100), das eine Vielzahl von Gate-Leitungen (GL), eine Vielzahl von Datenleitungen (DL) und eine Vielzahl von Pixeln einschließt, die mit den Gate-Leitungen (GL) und den Datenleitungen (DL) verbunden sind und so konfiguriert sind, dass sie ein Bild auf der Grundlage von Eingangsbilddaten anzeigen;
einen Gate-Treiber (300), der so konfiguriert ist, dass er Gate-Signale an die Gate-Leitungen (GL) ausgibt;
einen Datentreiber (500), der so konfiguriert ist, dass er Datenspannungen an die Datenleitungen (DL) ausgibt; und
den Leistungsspannungsgenerator (600) nach einem vorstehenden Anspruch, der so konfiguriert ist, dass er die Ausgangsspannung an die Pixel anlegt.

8. Anzeigevorrichtung nach Anspruch 7, weiter umfassend:
eine Ansteuerungssteuereinheit (200), die so konfiguriert ist, dass sie dem Leistungsspannungsgenerator (600) das Zielsignal ausgibt, das einen Zielstrom repräsentiert, der auf der Grundlage der Last der von der Anzeigevorrichtung empfangenen Eingangsbilddaten bestimmt wird, wobei der Zielstrom mit zunehmender Last der Eingangsbilddaten ansteigt und einen Sättigungsstrom aufrechterhält, nachdem der Zielstrom den Sättigungsstrom erreicht hat.

## Revendications

1. Générateur de tension d'alimentation destiné à générer une tension de sortie pour piloter un dispositif d'affichage, le générateur de tension d'alimentation comprenant :
un survolteur (610) comprenant un inducteur (L), une première diode (D1) et un commutateur (T), dans lequel le survolteur (610) est configuré pour élever une tension d'entrée jusqu'à une tension de sortie sur la base d'une ouverture/fermeture du commutateur (T) et dans lequel :
l'inducteur (L) inclut une première borne configurée pour recevoir la tension d'entrée et une seconde borne connectée à une première électrode de la première diode (D1),
le commutateur (T) inclut une électrode de grille, une électrode de source et une électrode de drain, l'électrode de drain étant connectée à la première électrode de la première diode (D1), l'électrode de source étant connectée à la masse, et
une seconde électrode de la première diode (D1) est configurée pour fournir la tension de sortie ;
un capteur de tension (620) connecté à la seconde électrode et configuré pour générer une tension de détection en détectant la tension de sortie ;
un dispositif de commande de tension constante (630) configuré pour générer un premier signal de commutation en comparant la tension de détection à une tension de référence ;
un circuit de lissage de signal (650) présentant une entrée connectée à l'électrode de grille du commutateur (T) et une sortie connectée à un dispositif de commande de courant constant (640), dans lequel le circuit de lissage de signal est configuré pour convertir un signal de modulation de largeur d'impulsion au niveau de l'électrode de grille du commutateur (T) en un signal de courant continu, dans lequel le dispositif de commande de courant constant (640) est configuré pour comparer le signal de courant continu et un signal cible (TD) et pour générer un gain sur la base d'un rapport entre le signal de courant continu et le signal cible, dans lequel le dispositif de commande de courant constant (640) est configuré pour couper le générateur de tension d'alimentation en fournissant un gain nul lorsqu'une différence entre le signal cible et le signal de courant continu est supérieure ou égale à un seuil, dans lequel le signal cible (TD) est basé sur une charge de données d'image d'entrée reçues par le dispositif d'affichage ; et
un opérateur de gain (MU) configuré pour générer un second signal de commutation, qui est le signal de modulation de largeur d'impulsion, en multipliant le gain par le premier signal de commutation et configuré pour appliquer le second signal de commutation à l'électrode de grille pour commander l'ouverture/fermeture du commutateur (T).

2. Générateur de tension d'alimentation selon la revendication 1, dans lequel le dispositif de commande de courant constant inclut un second opérateur incluant une première électrode d'entrée au niveau de laquelle le signal cible est entré, une seconde électrode d'entrée configurée pour recevoir le second signal de commutation, et une électrode de sortie connectée à l'opérateur de gain (MU) et configurée pour fournir le gain à l'opérateur de gain (MU).

3. Générateur de tension d'alimentation selon une quelconque revendication précédente, dans lequel, lorsque la tension d'entrée du survolteur (610) est VI, la tension de sortie du survolteur (610) est VO, un courant de sortie du survolteur (610) est IO, un facteur de marche du signal au niveau de la grille du commutateur (T) est D, une inductance de l'inducteur (L) est L, et un temps est t, le courant de sortie du survolteur IO est représenté comme suit : $IO = \frac{{VI}^{2} {D}^{2} t}{2 L \left(VO-VI\right)}$

4. Générateur de tension d'alimentation selon la revendication 1, dans lequel :
le circuit de lissage de signal (650) inclut une seconde diode (D2), une résistance (RX) et un condensateur (CX) ;
la seconde diode (D2) inclut une première électrode connectée à l'électrode de grille du commutateur (T) et une seconde électrode connectée à une première borne de la résistance (RX) ;
la résistance (RX) inclut la première borne connectée à la seconde électrode de la seconde diode (D2) et une seconde borne connectée à la masse ; et
le condensateur (CX) inclut une première électrode connectée à la seconde électrode de la seconde diode (D2) et une seconde électrode connectée à la masse.

5. Générateur de tension d'alimentation selon une quelconque revendication précédente, dans lequel le capteur de tension (620) inclut une première résistance de détection (RS1) et une seconde résistance de détection (RS2),
la première résistance de détection (RS1) inclut une première borne connectée à la seconde électrode de la première diode (D1) et une seconde borne connectée à une première borne de la seconde résistance de détection (RS2), et
la seconde résistance de détection (RS2) inclut une première borne connectée à la seconde borne de la première résistance de détection (RS1) et une seconde borne connectée à la masse.

6. Générateur de tension d'alimentation selon une quelconque revendication précédente, dans lequel le dispositif de commande de tension constante (630) inclut un premier opérateur incluant une première électrode d'entrée configurée pour recevoir la tension de détection, une seconde électrode d'entrée configurée pour recevoir la tension de référence, et une électrode de sortie connectée à l'opérateur de gain (MU) et configurée pour fournir le premier signal de commutation à l'opérateur de gain (MU).

7. Dispositif d'affichage comprenant :
un panneau d'affichage (100) incluant une pluralité de lignes de grille (GL), une pluralité de lignes de données (DL) et une pluralité de pixels connectés aux lignes de grille (GL) et aux lignes de données (DL) et configurés pour afficher une image sur la base de données d'image d'entrée ;
un pilote de grille (300) configuré pour fournir des signaux de grille aux lignes de grille (GL) ;
un pilote de données (500) configuré pour fournir des tensions de données aux lignes de données (DL) ; et
le générateur de tension d'alimentation (600) selon une quelconque revendication précédente configuré pour appliquer la tension de sortie aux pixels.

8. Dispositif d'affichage selon la revendication 7 comprenant en outre :
un dispositif de commande de pilotage (200) configuré pour fournir au générateur de tension d'alimentation (600) le signal cible représentatif d'un courant cible déterminé sur la base de la charge des données d'image d'entrée reçues par le dispositif d'affichage, dans lequel le courant cible augmente à mesure que la charge des données d'image d'entrée augmente et maintient un courant de saturation après que le courant cible a atteint le courant de saturation.
